# EUROPEAN PATENT APPLICATION

(11) **EP 2 506 298 A1**
(43) Date of publication of application: **03.10.2012**
(21) Application number: 10832826.1
(22) Date of filing: 19.11.2010
(51) Int. Cl.: H01L 23/12, H01L 25/10, H01L 25/11, H01L 25/18

(54) **PRODUCTION METHOD FOR ELECTRONIC DEVICE, ELECTRONIC DEVICE, PRODUCTION METHOD FOR ELECTRONIC DEVICE PACKAGE, AND ELECTRONIC DEVICE PACKAGE**

(30) Priority: 27.11.2009 JP 2009270110
(71) Applicant: Sumitomo Bakelite Company Limited, Shinagawa-ku Tokyo 140-0002 (JP)
(72) Inventor: KAWATA, Masakazu, Tokyo 140-0002 (JP); TAKEUCHI, Etsu, Tokyo 140-0002 (JP); KUSUNOKI, Junya, Tokyo 140-0002 (JP); SUGIYAMA, Hiromichi, Tokyo 140-0002 (JP)
(74) Representative: Vossius, Corinna
(86) International application number: PCT/JP2010/006794
(87) International publication number: WO 2011/064971

(57) **Abstract**

Disclosed is a method for manufacturing an electronic device, the method including: placing an electronic component on a substrate 11; forming standing portions 13 on the surface of the substrate 11 on which the electronic component 10 is placed, the standing portions 13 comprising a thermally decomposable resin; applying an encapsulating material 14 so as to encapsulate the electronic component 10 and cover around the standing portions 13 while exposing a portion of each of the standing portions 13 from the surface of the encapsulating material 14; heating the standing portions 13 to decompose and remove the standing portions 13, thereby forming holes 141 through the encapsulating material 14; and placing a conductive material 15 in the holes 141.

## Description

### TECHNICAL FIELD

The present invention relates to a method for manufacturing an electronic device, an electronic device, a method for manufacturing an electronic device package and an electronic device package.

### BACKGROUND ART

With the recent requirements of higher functionality, lightness, thinning, miniaturization and compactization in electronic devices, high-density integration and high-density mounting of electronic components are in progress.
As a semiconductor device for high-density mounting, there has been proposed a semiconductor package having a package-on-package (POP) structure, in which a first semiconductor element is mounted on a substrate, and a substrate having a second semiconductor element mounted thereon is placed over the first semiconductor device.
As the semiconductor device comprising the first semiconductor element which is used in the semiconductor package having the POP structure, a structure as shown in Fig. 8 has been proposed (see, for example, patent document 1).

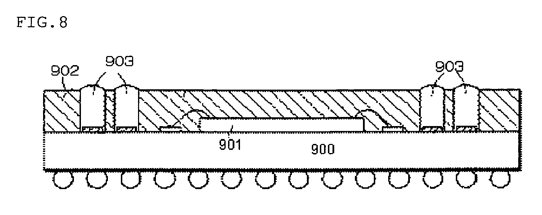

The semiconductor device shown in Fig. 8 comprises a substrate 900 and a first semiconductor element 901 mounted on the substrate 900, in which the first semiconductor element 901 is covered with a molding material 902. In addition, holes are formed in the molding material 902, and a conductive material 903 is filled in the holes.

### RELATED DOCUMENT

### PATENT DOCUMENT

Patent Document 1: Japanese Unexamined Patent Application Publication No. 2009-520366

### DISCLOSURE OF THE INVENTION

In general, the holes in the molding material 902 are formed by irradiating the molding material 902 with a laser beam. However, in the case in which the molding material is irradiated with a laser beam, it is difficult to accurately control the intensity or irradiation time of the laser beam, and the surface of the substrate 900 is etched by the laser beam, thus making it difficult to obtain a highly reliable semiconductor package.

In accordance with the present invention, there is provided a method for manufacturing an electronic device, comprising: placing an electronic component on a substrate; forming standing portions on the surface of the substrate on which the electronic component is placed, the standing portions comprising a thermally decomposable resin; applying an encapsulating material so as to encapsulate the electronic component and cover around the standing portions while exposing a portion of each of the standing portions from the surface of the encapsulating material; heating the standing portions to decompose and remove the standing portions, thereby forming holes through the encapsulating material; and placing a conductive material in the holes.

In the present invention, the standing portions are formed on the substrate having the electronic component placed thereon, and the encapsulating material is applied in such a manner that it covers around the standing portions while a portion of each of the standing portions is exposed from the surface of the encapsulating material. Then, the standing portions are thermally decomposed by heating, thereby forming the holes through the encapsulating material.
On this account, a highly reliable electronic device may be obtained without etching the substrate surface by a laser beam.

Furthermore, in accordance with the present invention, there may also be provided an electronic device manufactured according to the above-described manufacturing method.
In addition, in accordance with the present invention, there may also be provided a method for manufacturing an electronic device package comprising an electronic device, manufactured according to the above-described semiconductor device manufacturing method, and an additional electronic device stacked with the manufactured electronic device, the method comprising: mounting the additional electronic device on the electronic device, in such a manner that a conductive material in the manufactured electronic device comes into contact with an electrode formed on the additional electronic device, thereby obtaining a stack composed of the manufactured electronic device and the additional electronic device; and heating the stack to bond the conductive material to the electrode of the additional electronic device. Additionally, there may also be provided an electronic device package manufactured according to the above-described electronic device package manufacturing method.

### EFFECT OF THE INVENTION

According to the present invention, there are provided an electronic device manufacturing method capable of obtaining a highly reliable electronic device, an electronic device, an electronic device package manufacturing method and an electronic device package.

### BRIEF DESCRIPTION OF THE DRAWINGS

Fig. 1 is a cross-sectional view showing an electronic device manufacturing process related to one embodiment of the present invention.
Fig. 2 is a plan view showing an arrangement of standing portions which are used in an electronic device.
Fig. 3 is a cross-sectional view showing an electronic device manufacturing process.
Fig. 4 is a cross-sectional view showing an electronic device manufacturing process.
Fig. 5 is a cross-sectional view showing an electronic device manufacturing process.
Fig. 6 is a cross-sectional view showing an electronic device package manufacturing process.
Fig. 7 is a cross-sectional view showing an alternative embodiment of the present invention.
Fig. 8 is a view showing an electronic device according to the prior art.

### DESCRIPTION OF EMBODIMENTS

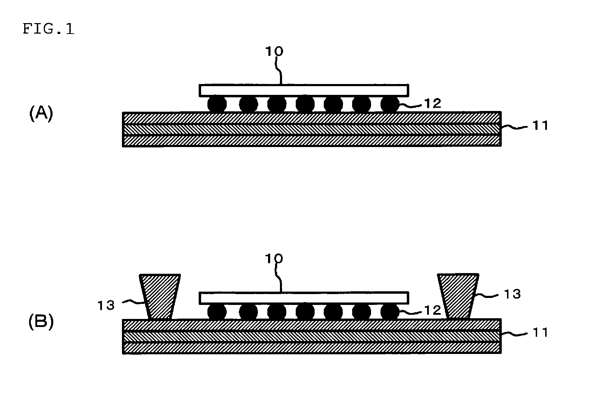

Hereinafter, an embodiment of the present invention will be described with reference to Figs. 1 to 6.
First, the summary of this embodiment will be descried.
A method of manufacturing an electronic device according to this embodiment comprises: placing an electronic component 10 on a substrate 11; forming standing portions 13 on the surface of the substrate 11 on which the electronic component 10 is placed, the standing portions 13 comprising a thermally decomposable resin; applying an encapsulating material 14 so as to encapsulate the electronic component 10 and cover around the standing portions 13 while exposing a portion of each of the standing portions 13 from the surface of the encapsulating material 14; heating the standing portions 13 to decompose and remove the standing portions 13, thereby forming holes 141 through the standing portions 13; and placing a conductive material 15 in the holes 141.
In this embodiment, the electronic device is a semiconductor device 1, and the electronic component is a semiconductor chip 10.

Hereinafter, the method of manufacturing the electronic device according to this embodiment will be described in detail.
First, as shown in Fig. 1A, the semiconductor chip 10 is mounted on the substrate 11.
The substrate 11 is a semiconductor chip mounting substrate which is the so-called both-sided circuit substrate or multilayer circuit substrate. The substrate 11 may consist of either only a core layer, or a build-up layer deposited on the surface of the core layer, or only the build-up layer.
The build-up layer is an alternating stack of an insulating layer and a conductive circuit layer, and the core layer consists of the insulating layer and the conductive circuit layer.
Although not shown, a conductive circuit layer (circuit) is formed on the front and back surface of the substrate 11.
The semiconductor chip 10 is electrically connected with the conductive circuit layer of the substrate 11. In this embodiment, the semiconductor chip 10 is electrically connected with the conductive circuit layer of the substrate 11 through solder bumps 12 formed on the back surface of the semiconductor chip 10. The solder bump 12 may be made of a lead-free solder or a high-melting-point solder containing lead.

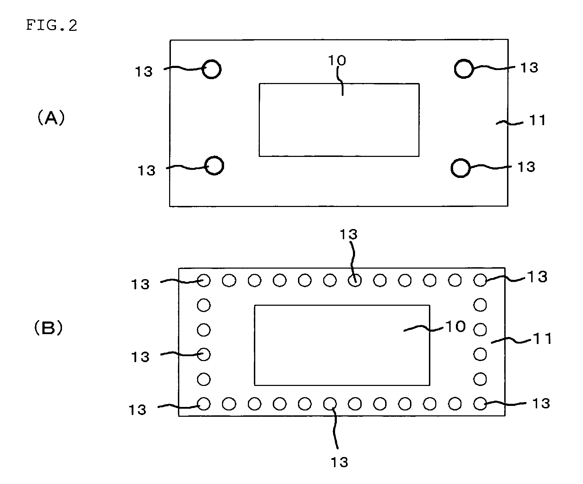

Then, as shown in Fig. 1B, standing portions 13 are formed on the substrate 11. The standing portions 13 are formed so as to surround the semiconductor chip 10 when viewed from the surface of the substrate 11. For example, the standing portions 13 may be formed at the four corners of the substrate 11 as shown in Fig. 2A, or may be formed so as to surround the semiconductor chip 10 as shown in Fig.2B.
The standing portions 13 are formed in a columnar shape, such as a circular or rectangular columnar shape.
The height of the standing portions 13 from the surface of the substrate 11 is higher than the height of the semiconductor chip 10 from the substrate surface and is, for example, 10 to 1,000 µm. The standing portions 13 are formed directly on the conductive circuit layer of the substrate 11 and cover a portion of the conductive circuit layer.

The standing portions 13 comprise a thermally decomposable resin. The standing portions 13 preferably comprise the thermally decomposable resin as their main component (when the standing portions 13 comprise a solvent, the content of the thermally decomposable resin is 50 wt% or more based on the total weight excluding the solvent). Examples of the thermally decomposable resin component of the standing portions 13 include polycarbonate-based resin, polyacetal-based resin, polyester-based resin, polyamide-based resin, polyimide-based resin, polyether-based resin, polyurethane-based resin, (meth)acrylate-based resin and the like. From the viewpoint of thermal decomposability, the standing portions 13 preferably comprise a resin, selected from the group consisting of these resins, in an amount of 50 wt% or more (when the standing portions 13 comprise a solvent, the content of the thermally decomposable resin is 50 wt% or more based on the total weight excluding the solvent).
Among these resins, the polycarbonate-based resin is preferably used as the main component of the standing portions 13 in order to effectively shorten the time of thermal decomposition of the standing portions 13 as described later.
In addition, the resin composition forming the standing portions 13 may comprise only one resin or may comprise two or more resins. In this specification, the term "resin composition" is also referred to when the standing portions 13 are made of one resin.

Examples of the polycarbonate-based resin include, but are not specifically limited to, polypropylene carbonate, polyethylene carbonate, 1,2-polybuthylene carbonate, 1,3-polybuthylene carbonate, 1,4-polybuthylene carbonate, cis-2,3-polybuthylene carbonate, trans-2,3-polybuthylene carbonate, α,β-polyisobutylene carbonate, α, γ-polyisobutylene carbonate, cis-1,2-polycyclobutylene carbonate, trans-1,2-polycyclobutylene carbonate, cis-1,3-polycyclobutylene carbonate, trans-1,3-polycyclobutylene carbonate, polyhexene carbonate, polycyclopropene carbonate, polycyclohexene carbonate, 1,3-polycyclohexane carbonate, poly(methylcyclohexene carbonate), poly(vinylcyclohexene carbonate), polydihydronaphthalene carbonate, polyhexahydrostyrene carbonate, polycyclohexanepropylene carbonate, polystyrene carbonate, poly(3-phenylpropylene carbonate), poly(3-trimethylsilyloxy propylene carbonate), poly(3-methacryloyloxy propylene carbonate), polyperfluoro propylene carbonate, polynorbornene carbonate, polynorbornane carbonate, and combinations thereof.
Examples of the polynorbornene carbonate resin include exo-polynorbornene carbonate, endo-polynorbornene carbonate, trans-polynorbornene carbonate, cis-polynorbornene carbonate and the like.

In addition, examples of the polycarbonate-based resin include a polypropylene carbonate/polycyclohexene carbonate copolymer, a 1,3-polycyclohexane carbonate/polynorbornene carbonate copolymer, a poly[(oxycarbonyloxy-1,1,4,4,-tetramethylbutane)-alt-(oxycarbonyloxy-5-norborne-2-e ndo-3-endo-dimethane)], poly[(oxycarbonyloxy-1,4-dimethylbutane)-alt-(oxycarbonyloxy-5-norbornene-2-endo-3-endo-dimethane)], poly[(oxycarbonyloxy-1,1,4,4-tetramethylbutane)-alt-(oxycarbonyloxy-p-xylene)], and poly[(oxycarbonyloxy-1,4-dimethylbutane)-alt-(oxycarbonyloxy-p -xylene)], and the like.
Examples of the 1,3-polycyclohexane carbonate/polynorbornene carbonate copolymer include a 1,3-polycyclohexane carbonate/exo-polynorbornene carbonate copolymer, a 1,3-polycyclohexane carbonate/endo-polynorbornene carbonate copolymer and the like.

In addition, the polycarbonate-based resin may also be a polycarbonate resin having at least two cyclic groups. The number of the cyclic groups is two or more, preferably 2 to 5, more preferably 2 or 3, and even more preferably 2. When the polycarbonate-based resin contains this number of cyclic groups, it will have excellent adhesion to the substrate 11.

Although the plurality of cyclic groups may form a crosslinked polycyclic structure in which the cyclic groups are linked end-to-end, they preferably form a condensed polycyclic structure in which they are linked side-by-side. In this case, the heat resistance in the process of encapsulation with an encapsulating material 14 can be ensured while the time of thermal decomposition of the standing portions 13 can be shortened.
In addition, each of the cyclic groups is preferably 5-membered or 6-memberred. In this case, the planarity of the carbonate structural units can be maintained, and the solubility in a solvent can be further stabilized.
Each of such cyclic groups is preferably an alicyclic compound. If each of the cyclic groups is an alicyclic compound, the above-described effects will be more remarkably exhibited.

In view of these considerations, carbonate structural units in the polycarbonate-based resin particularly preferably have a structure represented by, for example, the following formula (1):

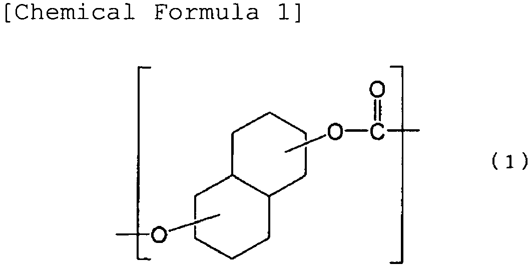

Meanwhile, the polycarbonate-based resin having the carbonate structural units represented by formula (1) can be obtained by polycondensation of decalin diol with diester carbonate such as diphenyl carbonate.

In addition, in the carbonate structural unit represented by formula (1), carbon atoms linked to the hydroxyl groups of decalin diol are each bonded to carbons constituting decalin (i.e., two cyclic groups forming a condensed polycyclic structure), while three or more carbon atoms are preferably interposed between these carbon atoms linked to the hydroxyl groups. In this case, the decomposability of the polycarbonate-based resin can be controlled, and as a result, the heat resistance of the resin in the process of encapsulation with an encapsulating material 14 can be ensured while the time of thermal decomposition of the standing portions 13 can be shortened. In addition, the solubility of the resin in a solvent can be further stabilized.

Examples of this carbonate structural unit include those represented by the following formulae (1A) and (1B):

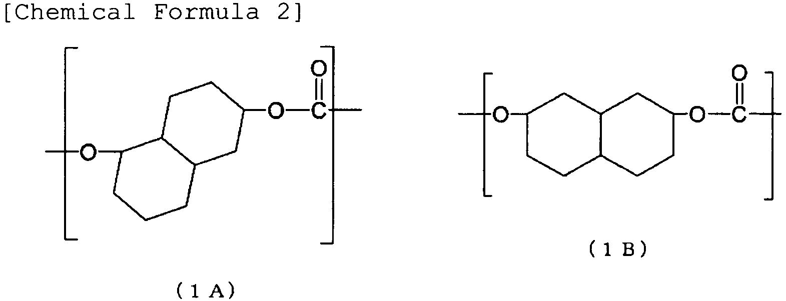

Furthermore, each of the cyclic groups may be an alicyclic compound or a heteroalicyclic compound. Even if each of the cyclic groups is a heteroalicyclic compound, the above-described effects will be more remarkably exhibited.

In this case, carbonate structural units in the polycarbonate-based resin particularly preferably have a structure represented by the following formula (2):

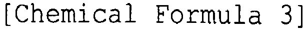

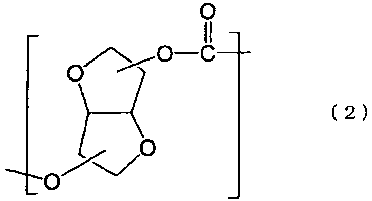

In addition, the polycarbonate-based resin having the carbonate structural units represented by formula (2) can be obtained by polycondensation of an ether diol represented by the following formula (2a) with a diester carbonate such as diphenyl carbonate:

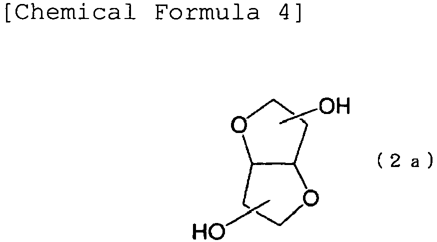

In addition, in the carbonate structural unit represented by formula (2), carbon atoms derived from the hydroxyl groups of the cyclic ether diol represented by formula (2a) are each bonded to carbons constituting the cyclic ether (i.e., two cyclic groups forming a condensed polycyclic structure), while three or more carbon atoms are preferably interposed between the carbon atoms linked to the hydroxyl groups. In this case, the heat resistance of the resin in the process of encapsulation with an encapsulating material 14 can be ensured while the time of thermal decomposition of the standing portions 13 can be shortened. In addition, the solubility of the resin in a solvent mentioned-below can be further stabilized.

Examples of this carbonate structural unit include
1,4:3,6-dianhydro-D-sorbitol(isosorbide) represented by the following formula (2A), and
1,4:3,6-dianhydro-D-mannitol(isomannide) represented by the following formula (2B):

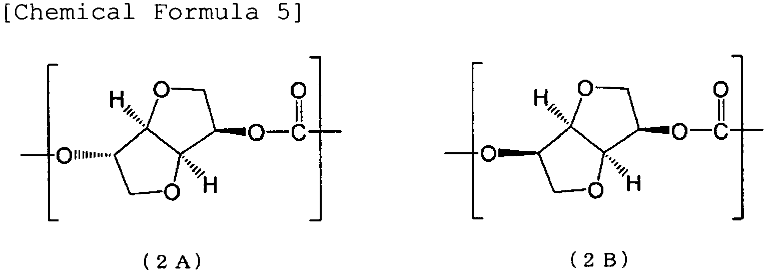

The weight-average molecular weight (Mw) of the polycarbonate-based resin is preferably 1,000 to 1,000,000, and more preferably 5,000 to 800,000.
When the weight-average molecular weight is equal to or greater than the lower limit of the above range, the affinity of the polycarbonate-based resin for the substrate 11 can be improved and the film-forming property of the resin can be further improved.
In addition, when the weight-average molecular weight is equal to or below upper limit of the above range, the solubility of the resin in various solvents and the thermal decomposability of the standing portions can be improved.

The polycarbonate-based resin can be prepared using, but not particularly to, various known polymerization methods, for example, a phosgene method (solution method) or an ester exchange method (melting method).

The resin component is preferably blended in an amount of 10 to 100 wt% based on the total weight of the components of the standing portions 13 (if the standing portions 13 contain a solvent, the total weight excluding the solvent). More preferably, it is blended in an amount of 50 wt% or more, particularly 80 to 100 wt%. When the content of the resin component is 10 wt% or more, particularly 80 wt% or more, the residue remaining after thermal decomposition of the standing portions 13 can be reduced. In addition, when the content of the resin component in the standing portions 13 is increased, the standing portions 13 can be thermally decomposed within a short time.

Generally, the temperature of the encapsulating material 14 in the encapsulation process is about 125 °C and the post-cure temperature of the encapsulating material 14 is about 175 °C. Thus, the resin component is preferably a resin component which is difficult to thermally decompose at 125 °C and is thermally decomposed at 175 °C. In this case, the exfoliation or deformation of the standing portions 13 in the process of encapsulation with the encapsulating material 14 can be inhibited and the post-cure of the encapsulating material 14 can be carried out simultaneously with the thermal decomposition and removal of the standing portions 13, whereby the process of manufacturing the electronic device can be simplified.

Particularly preferred examples of the resin component include polypropylene carbonate, 1,4-polybuthylene carbonate, and a 1,3-polycyclohexane carbonate/polynorbornene carbonate copolymer, which are difficult to thermally decompose at the temperature of encapsulation by the encapsulating material 14 and have excellent thermal decomposability at the temperature of encapsulation by the encapsulating material 14 or higher.

Moreover, when the thermally decomposable resin composition contains polycarbonate-based resin, polyacetal-based resin, polyester-based resin, polyamide-based resin, polyimide-based resin, polyether-based resin, polyurethane-based resin, or (meth)acrylate-based resin, it preferably contains a photoacid generator. In this case, the temperature of thermal decomposition of the standing portions 13 can be lowered by exposing the standing portions 13 (thermally decomposable resin composition) to light. When the standing portions 13 are exposed to light after the semiconductor chip 10 and the standing portions 13 are encapsulated with the encapsulating material 14, the temperature of thermal decomposition of the standing portions 13 can be lowered, thermal damage to the electronic device can be prevented, and the standing portions 13 can be removed simultaneously with the post-cure of the encapsulating material 14.

Hereinafter, description will be made about a mechanism in which the temperature of thermal decomposition is lowered when a polypropylene carbonate resin that is a polycarbonate-based resin is used as the resin component.
As shown in the following formula (3), H⁺ derived from the photoacid generator protonates the carbonyl oxygen of the polypropylene carbonate resin and further transfer the polar transition state, thus making unstable tautomeric intermediates [A] and [B]. Then, the intermediate [A] is subjected to thermal cleavage in which it is fragmented into acetone and CO₂, and thus the temperature of thermal decomposition is lowered. In addition, the intermediate [B] produces a propylene carbonate which then forms a thermally cyclized structure which is fragmented into CO₂ and propylene oxide, and thus the temperature of thermal decomposition is lowered.

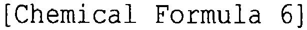

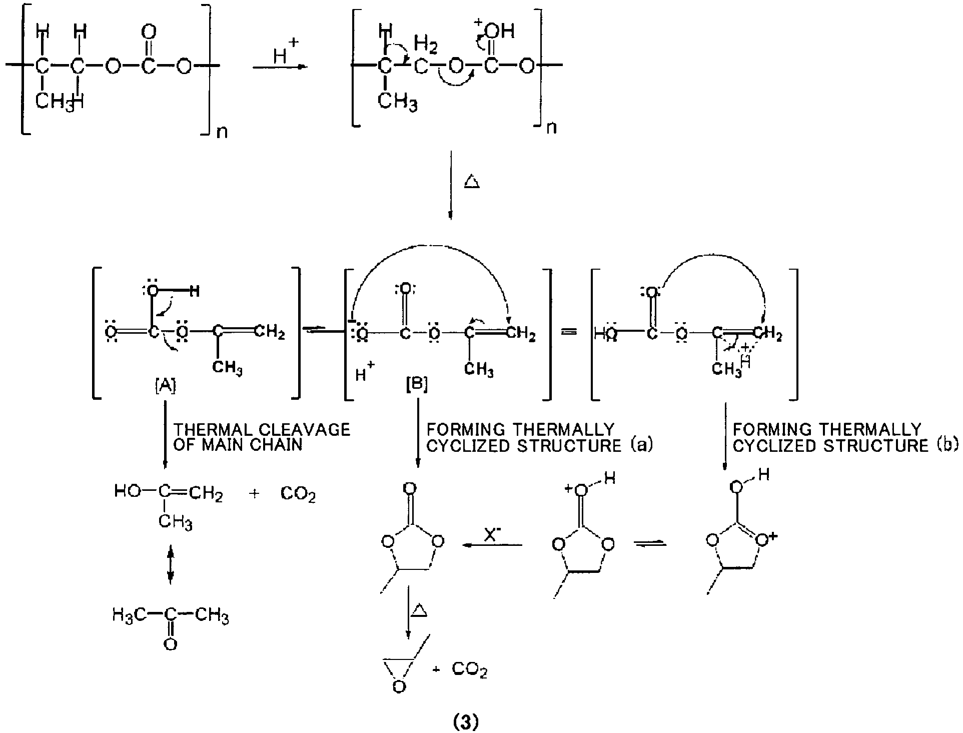

The photoacid generator is a compound that generates acid by irradiation with chemical rays. The photoacid generator is not specifically limited, and examples thereof include nucleophilic halides, complex metal halide anions, and the like. More specific examples of the photoacid generator include tetrakis(pentafluorophenyl)borate-4-methylphenyl[4-(1-methylet hyl)phenyl]iodonium (DPI-TPFPB), tris(4-t-butyl phenyl)sulfoniumtetrakis-(pentafluorophenyl)borate (TTBPS-TPFPB), tris(4-t-butyl phenyl)sulfoniumhexafluorophosphate (TTBPS-HFP), triphenylsulfoniumtriflate(TPS-Tf), bis(4-tert-butylphenyl)iodoniumtriflate (DTBPI-Tf), triazine (TAZ-101), triphenylsulfoniumhexafluoroantimonate (TPS-103), triphenylsulfonium bis(perfluoromethanesulfonyl)imide (TPS-N1), di-(p-t-butyl)phenyliodonium, bis(perfluoromethanesulfonyl)imide(DTBPI-N1), triphenylsulfonium, tris(perfluoromethanesulfonyl)methide (TPS-C1), di-(p-t-butylphenyl)iodoniumtris(perfluoromethanesulfonyl)meth ide (DTBPI-C1), and the like.

The content of the photoacid generator is preferably 0.1 to 15 parts by weight, and particularly preferably 0.5 to 10 parts by weight, based on 100 parts by weight of the resin component. In this case, the temperature of thermal decomposition of the thermally decomposable resin composition can be effectively lowered by exposing the resin composition to light, and the residue remaining after thermal decomposition can be further reduced.

The resin composition constituting the standing portions 13 may contain, in addition to the photoacid generator, a sensitizer that functions to express or increase the reactivity of the photoacid generator to light of a certain type or wavelength.

Examples of the sensitizer include, but are not limited to, anthracene, phenanthrene, chrysene, benzopyrene, fluoranthene, rubrene, pyrene, xanthone, indanthrene, thioxanthene-9-one, 2-isopropyl-9H-thioxanthene-9-one, 4-isopropyl-9H-thioxanthene-9-one, 1-chloro-4-propoxythioxanthone, and mixtures thereof. The content of the sensitizer is preferably 100 parts by weight or less, and more preferably 50 parts by weight or less, based on 100 parts by weight.

In addition, the resin composition constituting the standing portions 13 may contain, for example, an acid scavenger, in addition to the above-described components. The acid scavenger is a component that functions to prevent an acid, generated by irradiation with light, from diffusing to the portion of the resin composition that is not irradiated with light. In other words, the acid scavenger is a component that functions to prevent an enhancement of the solubility in a developer solution and a decrease in the temperature of thermal decomposition of the resin composition in the portion of the resin composition, which was not irradiated with light. When the resin composition contains this acid scavenger, the degree of patterning of the resin composition by development and thermal decomposition can be further increased.

Examples of the acid scavenger include tri(n-propyl)amine, triethylamine, amines (sec-amines or tert-amines) such as a compound represented by the following formula (4) or a compound represented by the following formula (5), and mixtures thereof.

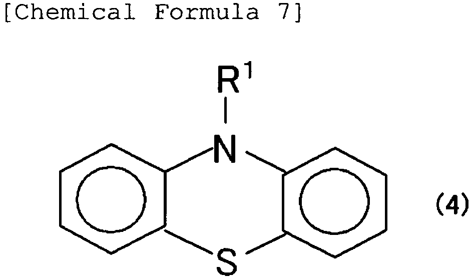

In formula (4), R¹ is H or an alkyl group.

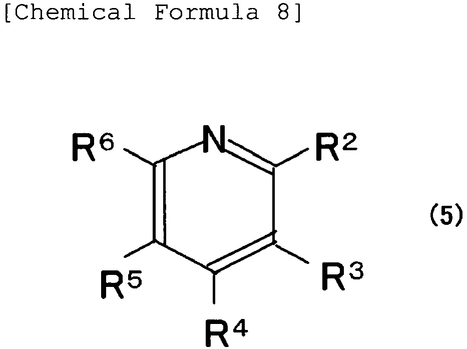

In formula (5), R² to R⁶ are H, or arbitrary two of R² to R⁶ are a methyl group and the remaining are H.

Among these compounds, at least one compound selected from the group consisting of the compound represented by formula (4) and the compound represented by formula (5) is preferably used. More preferably, the compound represented by formula (4) is used. In this case, the sensitivity of the resin composition to light can be increased while an enhancement of the solubility in a developer solution and a decrease in the temperature of thermal decomposition of the resin composition can be more effectively prevented in the portion of the resin composition, which was not irradiated with light.

The content of the acid scavenger is preferably 0.01 to 10 parts by weight, and more preferably 0.02 to 8 parts by weight, based on 100 parts by weight of the photoacid generator. In this case, an enhancement of the solubility and a decrease in the temperature of thermal decomposition of the resin composition can be more effectively prevented in the portion of the resin composition, which was not irradiated with light.

In addition, the resin composition constituting the standing portions 13 may contain an antioxidant. The antioxidant functions to prevent the generation of undesired acid or the natural oxidation of the resin composition.

Preferred examples of the antioxidant that may be used in the present invention include, but are not specifically limited to, Ciba IRGANOX (trademark) 1076 and Ciba IRGAFOS (trademark) 168, which are commercially available Ciba Fine Chemicals (Tarry Town, New York, USA).

In addition, other examples of the antioxidant that may be used in the present invention include Ciba Irganox (trademark) 129, Ciba Irganox 1330, Ciba Irganox 1010, Ciba Cyanox (trademark) 1790, Ciba Irganox 3114, Ciba Irganox 3125, and the like.

The content of the antioxidant is preferably 0.1 to 10 parts by weight, and more preferably 0.5 to 5 parts by weight, based on 100 parts by weight of the resin component.

In addition, the resin composition constituting the standing portions 13 may, if necessary, contain additives, including an acrylic-based, silicone-based, fluorine-based or vinyl-based leveling agent, a silane coupling agent, and the like.

Examples of the silane coupling agent include, but are not specifically limited to, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, N-phenyl-3-aminopropyltrimethoxysilane, 3-mercaptopropylmethyldimethoxysilane, 3-mercaptopropyltrimethoxysilane, bis(triethoxypropyl)tetrasulfide, 3-isocyanatepropyltriethoxysilane, and the like, which may be used alone or as a mixture of two or more thereof.
When the resin composition constituting the standing portions 13 contains the silane coupling agent, the adhesion of the resin composition during patterning can be improved.

Herein, the 50% weight loss temperature of the thermally decomposable resin component that is contained in the thermal decomposable resin composition constituting the standing portions 13 is 400 °C or below, and preferably 350 °C or below. If the 50% weight loss temperature is 400 °C or below, the influence of heat on the semiconductor chip 10 or the resin composition for encapsulation during thermal decomposition of the standing portions 13 can be reduced.
In other words, when the 50% weight loss temperature is 400 °C or below, the standing portions 13 can be thermally decomposed by controlling the heating time without heating above 400 °C. Thus, the influence of heat on the semiconductor chip 10 or the encapsulating material 14 during thermal decomposition of the standing portions 13 can be reduced.

In addition, the difference between the 95% weight loss temperature and 5% weight loss temperature of the thermally decomposable resin component that is contained in the thermal decomposable resin composition constituting the standing portions 13 is preferably between 1 °C and 300 °C. More preferably, the difference between the 95% weight loss temperature and the 5% weight loss temperature is 5 to 200 °C. When the difference between the 95% weight loss temperature and the 5% weight loss temperature is 1 °C or above, a large amount of outgas can be prevented from being generated due to a rapid thermal decomposition reaction and from contaminating equipment. In addition, when the 95% weight loss temperature and the 5% weight loss temperature is 300 °C or below, the time required for thermal decomposition can be shortened, and thus damage to the semiconductor chip 10 or the encapsulating material 14 can be inhibited and the thermally decomposable resin composition can be made difficult to remain on the semiconductor chip 10.

In addition, the thermally decomposable resin component which is contained in the thermally decomposable resin composition preferably has a 5% weight loss temperature of 50 °C or above, particularly 100 °C or above. In this case, unnecessary thermal decomposition of the standing portions 13 during the process of manufacturing the semiconductor device 1 can be inhibited.

As used herein, the terms "50% weight loss temperature, "95% weight loss temperature" ant "5% weight loss temperature" mean the temperatures corresponding to weight losses of 50%, 95% and 5%, respectively, as measured by thermogravimetry (Tg)/differential thermal analysis (DTA). The TG/DTA analysis can be performed by precisely weighing about 10 mg of the thermally decomposable resin component and performing TG/DTA analysis using a TG/DTA system (manufactured by Seiko Instruments Inc.) in a nitrogen atmosphere at a heating rate of 5 °C/min.
Meanwhile, the 50% weight loss temperature of the thermally decomposable resin component can be set at 400 °C or below, for example, by selecting a straight or branched, thermally decomposable resin component having no alicyclic or aromatic skeleton.
In addition, the difference between the 95% weight loss temperature and the 5% weight loss temperature can be set at 1 to 300 °C, for example, by controlling the molecular weight distribution of the resin component of the thermally decomposable resin composition.
Furthermore, the 5% weight loss temperature can be set at 50 °C or above, for example, by controlling the molecular weight of the thermally decomposable resin component.

Methods of forming the standing portions 13 using the above-described resin composition include a spin coating method, a screen printing method, a dispense application method and the like.
When the standing portions 13 are formed by the spin coating method, a solvent is added to the resin composition to make a varnish state. The varnish-state resin composition is applied to the substrate 11 by the spin coating method. In this case, since the resin composition is applied over the entire surface of the substrate 11 so as to surround the semiconductor chip 10 on the substrate 11, the thermally decomposable resin composition excluding the portion constituting the standing portions 13 needs to be removed. Methods for removing the thermally decomposable resin composition include, but are not specifically limited to, methods of removing the resin composition by dry etching, development, heating, or the like.

The method of removing the resin composition by dry etching can be performed by forming a resist layer on portions in which the standing portions 13 are to be formed, dry-etching portions other than the portions in which the standing portions 13 to be formed, and removing the resist layer, thereby forming the standing portions 13, but is not specifically limited thereto. The methods of dry etching include plasma etching, reactive ion etching and the like, but the reactive ion etching method having excellent anisotropy and in which the shape of the standing portions 13 is stable is preferably used.

When the method of removing the resin composition by development and the method of removing the resin composition by heating are used, the resin composition preferably contains a photoacid generator.

In the method of removing the thermally decomposable resin composition by development, when the thermally decomposable resin composition is exposed to chemical rays, the solubility of the exposed portion in a developer solution will be increased and the solubility of the non-exposed portions (standing portions 13) in the developer solution will be reduced. The use of this difference in solubility in the developer solution can result in the formation of the standing portions 13.

Examples of the chemical rays include i-rays, g-rays and the like.
In addition, examples of the developing solution include solvents such as 2-heptanone, cyclopentanone or PGMEA, and alkali developer solutions such as an aqueous solution of tetramethylammonium hydroxide or an aqueous solution of sodium bicarbonate. Among them, the aqueous solution of tetramethylammonium hydroxide having a low environmental burden is preferably used.

In the method of removing the thermally decomposable resin composition by heating, when the resin composition is exposed to chemical rays, the thermal decomposition temperature of the exposed portion will be reduced, and the thermal decomposition temperature of the non-exposed portions (standing portions 13) will not change. The use of this difference in thermal decomposition temperature can result in the formation of the standing portions 13. Herein, examples of the chemical rays include i-line, g-line and the like, similar to the method of removing the resin composition by development.
In addition, the method of forming the standing portions 13 may also be performed by a screen printing method. In this case, the resin composition constituting the standing portions 13 is applied to the substrate 11 through a screen printing plate. Then, the resin composition is dried, thereby forming the standing portions 13.
In this case, the resin composition preferably contains no solvent, whereby a drying process can be omitted.
In addition, the standing portions 13 may also be formed using a dispenser. In this case, a solvent is added to the resin composition to make a varnish-state resin composition. The varnish is dispensed using a dispenser on portions in which the standing portions 13 are to be formed. Then, the dispensed varnish is dried, thereby forming the standing portions 13.

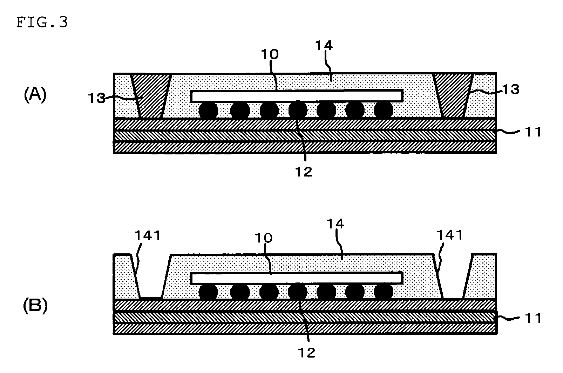

Then, as shown in Fig. 3A, the semiconductor chip 10 is encapsulated with an encapsulating material 14. Herein, the encapsulating material 14 completely encapsulates the semiconductor chip 10 while covering around the standing portions 13. In addition, the upper surface of the standing portions 13 is exposed from the surface of the encapsulating material 14, opposite to the surface of the substrate 11.
Meanwhile, in this embodiment, an encapsulating resin composition having low melting viscosity is used, and the encapsulating resin composition is also filled into the gap between the solder bumps 12 formed between the semiconductor chip 10 and the substrate 11.

The encapsulating resin composition constituting the encapsulating material 14 is preferably based on a cured resin composition containing, for example, an epoxy resin, a curing agent and an inorganic filler. The encapsulating material 14 composed of this composition can encapsulate the semiconductor chip 10 with excellent adhesion and, at the same time, the thermal expansion coefficient thereof can be relatively easily controlled.

Examples of the epoxy resin include crystalline epoxy resins such as biphenyl-type epoxy resin, bisphenol A-type epoxy resin, bisphenol F-type epoxy resin, stilbene-type epoxy resin or hydroquinone-type epoxy resin; novolak-type epoxy resins such as cresolnovolak-type epoxy resin, phenolnovolak-type epoxy resin or naphtholnovolak-type epoxy resin; phenolaralkyl-type epoxy resins such as a phenolaralkyl-type epoxy resin containing a phenylene skeleton, a phenolaralkyl-type epoxy resin containing a biphenylene skeleton, or a naphtholaralkyl-type epoxy resin containing a phenylene skeleton; trifunctional epoxy resins such as triphenolmethane-type epoxy resin or alkyl-modified triphenolmethane-type epoxy resin; modified phenol-type epoxy resins such as dicyclopentadiene-modified phenol-type epoxy resin or terpene-modified phenol-type epoxy resin; and heterocycle-containing epoxy resins such as triazine nucleus-containing epoxy resin. These epoxy resins may be used alone or in a combination of two or more thereof.

The epoxy resin that is used in the present invention is particularly preferably one represented by the following formula (6). Because the epoxy resin represented by formula (6) is bifunctional, the crosslinking density of the cured resin composition containing this epoxy resin can be inhibited to a low level, and thus the resin composition has a low thermal expansion coefficient. For this reason, the cured resin composition containing this epoxy resin is subjected to reduced stress in a solder reflow process (i.e., a process of heating the electronic device), and thus the magnitude of deformation of the electronics device package in this process is reduced. Furthermore, because the epoxy resin represented by the following formula (6) is a low-molecular-weight crystalline resin, it has low melting point, and the epoxy resin composition containing this has excellent flowability.

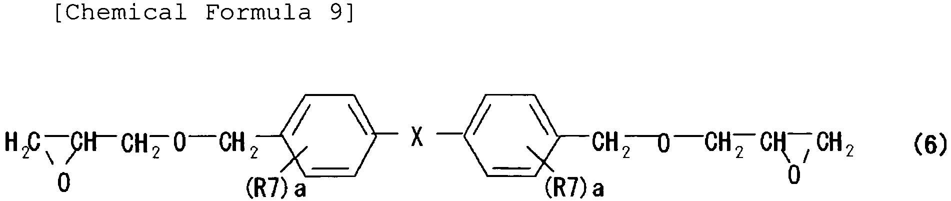

In formula (6), X is a group selected from among a single bond, -O-, -S-, and -R8CR8- wherein R8 are hydrogen or alkyl groups having 1 to 4 carbon atoms and may the same or different; R7 are alkyl groups having 1 to 6 carbon atoms and may be the same or different; and a is an integer ranging from 0 to 4.

The epoxy resin represented by formula (6) is more preferably 4,4'-diglycidoxybiphenyl, 3,3,5,5'-tetramethyl-4,4'-diglycidoxybiphenyl, or a melted mixture thereof. These compounds have an excellent balance of workability and practicality and make it possible to set the thermal expansion coefficient of the encapsulating material 14 at a low level.

Meanwhile, examples of the curing agents include amines such as straight-chain aliphatic diamines containing 2 to 20 carbon atoms include ethylenediamine, trimethylenediamine, tetramethylenediamine or hexamethylenediamine, methphenylenediamine, paraphenylenediamine, paraxylenediamine, 4,4'-diaminodiphenylmethane, 4,4'-diaminodiphenylpropane, 4,4'-diaminodiphenylether, 4,4'-diaminodiphenylsulfone, 4,4'-diaminodicyclohexane, bis(4-aminophenyl)phenylmethane, 1,5-diaminonaphthalene, methxylenediamine, paraxylenediamine, 1,1-bis(4-aminophenyl)cyclohexane, or dicyandiamide; resol-type phenol resins such as aniline-modified resol resin or dimethyl ether resol resin; novolak-type phenol resins such as phenolnovolak resin, cresolnovolak resin, tert-butylphenolnovolak resin, or nonylphenolnovolak resin; phenolaralkyl resin such as a phenolaralkyl resin containing a phenylene skeleton, or a phenolaralkyl resin containing a biphenylene skeleton; phenol resins having a condensed polycyclic structure such as a naphthalene skeleton or an anthracene skeleton; polyoxystyrene such as polyparaoxy styrene; acid anhydrides, including alicyclic acid anhydrides such as hexahydro anhydrous phthalic acid (HHPA) or methyltetrahydro anhydrous phthalic acid (MTHPA), and aromatic acid anhydrides such as anhydrous trimellitic acid (TMA), anhydrous pyromellitic acid (PMDA) or benzophenonetetracarboxylic acid (BTDA); polymercaptan compounds such as polysulfide, thioester or thioether; isocyanate compounds such as isocyanateprepolymer or blocked isocyanate; and organic acids, such as carboxylic acid-containing polyester resins. These compounds may be used alone or in a combination of two or more thereof.

Among them, a compound having at least two phenolic hydroxyl groups in one molecule is preferably used as the curing agent of the encapsulating agent 14. Examples of this curing agent include novolak-type phenol resins such as phenolnovolak resin, cresolnovolak resin, tert-butylphenolnovolak resin or nonylphenolnovolak resin; resol-type phenol resins; polyoxystyrene such as polyparaoxy styrene; phenolaralkyl resins containing a phenylene skeleton; and phenolaralkyl resins containing a biphenylene skeleton. When a compound selected from among these compounds is used, the thermal expansion coefficient of the encapsulating material can be set at a low level. These compounds are excellent in moisture resistance, reliability and the like.

As the curing agent having at least two phenolic hydroxylic groups in one molecule, a phenol resin represented by the following formula (7) is particularly preferably used. The phenol resin represented by formula (7) contains a fundamental skeleton having novolak-type phenol resin and triphenolmethane-type phenol resin. Because the phenol resin represented by formula (7) has novolak-type phenol resin as its fundamental skeleton, it has a short distance between the cross-linking points of the resin skeleton and exhibits good curability and moldability. In addition, because the phenol resin has triphenolmethane-type phenol resin as its fundamental skeleton, it contains three or more hydroxyl groups in one molecule, and thus has high crosslinking density, and a cured resin composition containing this phenol resin can have a high glass transition temperature (Tg) and low linear expansion coefficient, and can also have high strength. Accordingly, the resin composition containing the phenol resin represented by formula (7) has good curability leading to excellent moldability. In addition, the thermal expansion and shrinkage of the resin composition after molding, curing and thermal treatment are relatively low, and thus the amount of deformation of the resin composition in the semiconductor device 1 can be reduced.

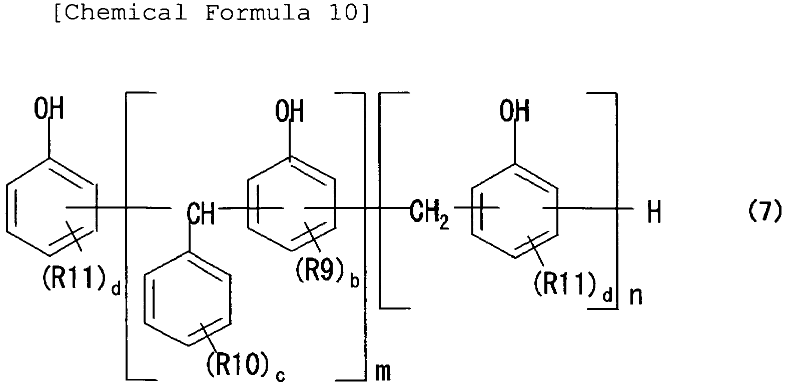

In formula (7), R9, R10 and R11 are selected from alkyl groups having 1 to 4 carbon atoms and may be the same or different; b is an integer ranging from 0 to 3; c is an integer ranging from 0 to 4; d is an integer ranging from 0 to 3; m and n represent the molar fractions of the respective units; and 0<m<1, 0<n<1, and m + n = 1.

In addition, in formula (7), the molar ratio of m and n (m/n) is preferably 1/5 to 5/1, and more preferably 1/2 to 2/1. In this case, the effects of both novolak-type phenol resin and triphenolmethane-type phenol resin can be synergistically enhanced.

Meanwhile, specific examples of the phenol resin represented by formula (7) include a compound represented by the following formula (8).

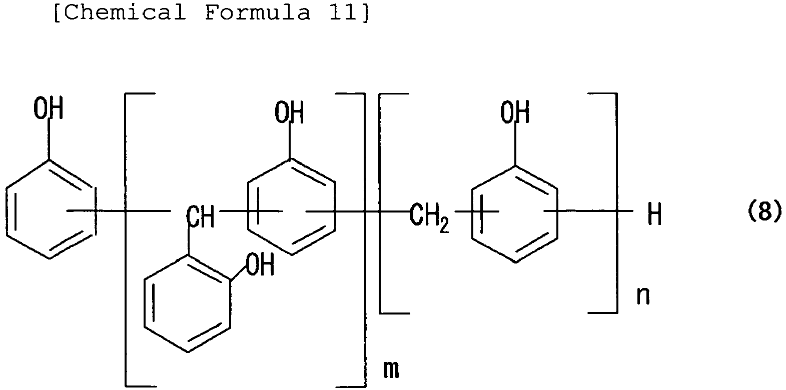

In formula (8), m and n represent the molar fractions of the respective units, and 0<m<1, 0<n<1, and m + n = 1.

Examples of the inorganic filler that is contained in the encapsulating material 14 include silica such as fused and crushed silica, fused spherical silica, crystalline silica or secondary flocculated silica, alumina, titanium white, aluminum hydroxide, talc, clay, mica, glass fiber, and the like, which may be used alone or in a combination of two or more thereof. Among them, fused spherical silica is particularly preferred. In this case, the thermal expansion coefficient of the encapsulating material 14 can be set at a low level.

Meanwhile, the shape of the inorganic filler is preferably as spherical as possible, and the filling amount thereof can be increased by using by particles having different particle sizes. However, the particle size of the inorganic filler is preferably 0.01 µm or more and 150 µm or less in view of filling into a space around the solder bumps 12.

Furthermore, the resin composition constituting the encapsulating material 14 may contain a silane coupling agent, a compound containing a hydroxyl group bonded to each of two or more adjacent carbon atoms constituting an aromatic ring, and a curing accelerator, in addition to the epoxy resin, the curing agent and inorganic filler.

Examples of the silane coupling agent include, but are not specifically limited to, epoxysilane, aminosilane, ureidosilane, mercaptosilane and the like, which may be used alone or in a combination of two or more thereof. When this silane coupling agent is contained in the resin composition, a reaction between the epoxy resin and the inorganic filler can occur, thus increasing the interfacial strength between the epoxy resin and the inorganic filler.

Examples of epoxysilane that may be used in the present invention include γ-glycidoxypropyltriethoxysilane, γ-glycidoxypropyltrimethoxysilane, γ-glycidoxypropylmethyldimethoxysilane and β-(3,4,epoxycyclohexyl)ethyltrimethoxysilane. Examples of aminosilane that may be used in the present invention include γ-aminopropyltriethoxysilane, γ-aminopropyltrimethoxysilane, N-β-(aminoethyl)-γ-aminopropyltrimethoxysilane, N-β-(aminoethyl)-γ-aminopropylmethyldimethoxysilane, N-phenyl-γ-aminopropyltriethoxysilane, N-phenyl-γ-aminopropyltrimethoxysilane, N-β-(aminoethyl)-γ-aminopropyltriethoxysilane, N-6-(aminohexyl)-3-aminopropyltrimethoxysilane and N-(3-(trimethoxysilylpropyl)-1,3-benzenedimethane. In addition, examples of ureidosilane that may be used in the present invention include γ-ureidopropyltriethoxysilane, hexamethyldisilazane and the like, and examples of mercaptosilane that may be used in the present invention include γ-mercaptopropyltrimethoxysilane.

Meanwhile, the silane coupling agent has the effects of reducing the viscosity of the resin composition and increasing the flowability of the resin composition, due to its synergistic effect with a compound containing a hydroxyl group bonded to each of two or more adjacent carbon atoms (hereinafter also referred to as the "hydroxyl group-containing compound"), as described below. Thus, in the case in which the resin composition contains the hydroxyl group-containing compound, it preferably also contains the silane coupling agent in order to maximize the effect caused by the addition of the hydroxyl group-containing compound. In this case, the resin composition constituting the encapsulating agent 14 can have sufficient flowability, even when it contains a large amount of a relatively highly viscous resin or a large amount of the inorganic filler.

Moreover, examples of the compound containing a hydroxyl group bonded to each of two or more adjacent carbon atoms constituting an aromatic ring (hydroxyl group-containing compound) include a compound represented by the following formula (9), a compound represented by the following formula (10), and the like.

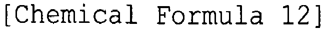

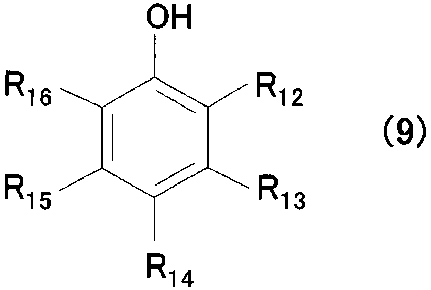

In formula (9), either of R12 and R16 is a hydroxyl group, and if one of R12 and R16 is a hydroxyl group, the other is hydrogen, a hydroxyl group or a group selected from substituents other than a hydroxyl group; and R13, R14 and R15 are each independently hydrogen, a hydroxyl group or a group selected from substituents other than a hydroxyl group and may be the same or different.

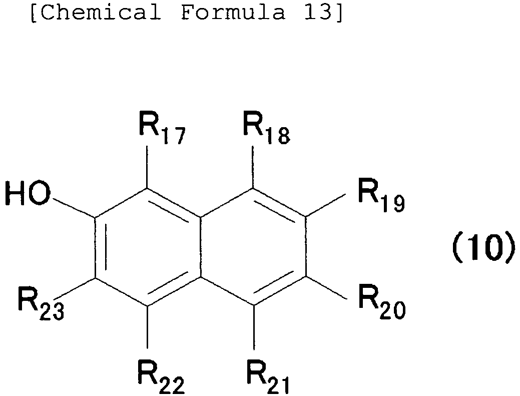

In formula (10), either of R17 and R23 is a hydroxyl group, and if one of R17 and R23 is a hydroxyl group, the other is hydrogen, a hydroxyl group or a group selected from substituents other than a hydroxyl group; R18, R19, R20, R21 and R22 are each independently selected from hydrogen, a hydroxyl group or a group selected from substituents other than a hydroxyl group and may be the same or different.

Meanwhile, specific examples of the compound represented by formula (9) include compounds represented by the following formula (11), including catechol, pyrogallol, gallic acid, gallic acid ester, and derivatives thereof. In addition, specific examples of the compound represented by formula (10) include compounds represented by the following formula (12), including 1,2-dihydroxynaphthalene, 2,3-dihydroxynaphthalene, and derivatives thereof. These compounds may be used alone or in a combination of two or more thereof. Among these compounds, a compound having a naphthalene ring as its main skeleton (i.e., 1,2-dihydroxynaphthalene, 2,3-dihydroxynaphthalene, or a derivative thereof) is more preferably selected, because the flowability and curability thereof are easy to control and the volatility thereof is low.

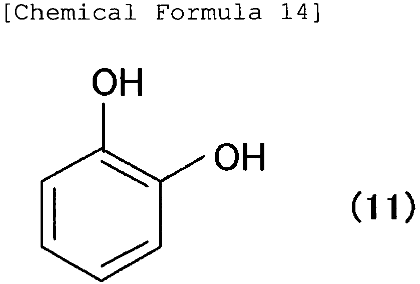

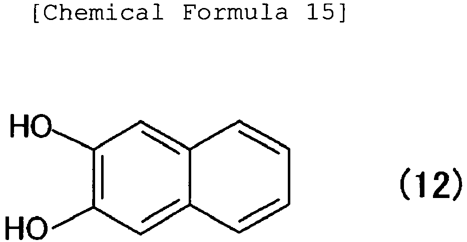

Furthermore, examples of the curing accelerator include, but are not specifically limited to, diazabicycloalkene and derivatives such as 1,8-diazabicyclo(5,4,0)undecene-7; amine-based compounds such as tributylamine or benzyldimethylamine; imidazole compounds such as 2-methylimidazole; organic phosphine such as triphenylphosphine or methyldiphenylphosphine; tetra-substituted phosphonium-tetra-substituted borate such as tetraphenylphosphonium-tetraphenylborate, tetraphenylphosphonium-tetra benzoic acid borate, tetraphenylphosphonium-tetra naphthoic acid borate, tetraphenylphosphonium-tetra naphthoyloxy borate or tetraphenylphosphonium-tetra naphthyloxy borate; and an adduct of triphenylphosphine with benzoquinone. These compounds may be used alone or in a combination of two or more thereof.

Furthermore, the resin composition constituting the encapsulating material may, if necessary, contain, in addition to the above-described components, various additives, including colorants such as carbon black; releasing agents, for example, natural wax such as carnauba wax, synthetic wax, higher fatty acids or their metal salts, paraffin, or propylene oxide; stress-relaxing agents such as silicone oil or silicone rubber; ion scavengers such as hydrotalcite; flame retardants such as aluminum hydroxide; and antioxidants.
Next, the encapsulating resin composition is molded using a molding method such as transfer molding, compression molding or injection molding, followed by curing, thereby obtaining the encapsulating material 14. As the molding method, compression molding is preferably used from a viewpoint of preventing the positional variation and exfoliation of the standing portions 13, but is not specifically limited thereto.
Herein, the encapsulating material 14 has the same size and shape as the substrate 11 when viewed from the surface of the substrate 11, and completely covers the substrate 11. The side of the encapsulating material 14 and the side of the substrate 11 are coplanar with each other. In this case, the semiconductor device can be prevented from being deformed.

Thereafter, the structure comprising the substrate 11, the standing portions 13, semiconductor chip 10 and the encapsulating material 14 (the structure shown in Fig. 3A) is heated, thereby thermally decomposing the standing portions 13. As a result, as shown in Fig. 3B, the standing portions 13 are removed to leave holes 141.
The heating temperature of the structure varies depending on the thermal decomposition temperature of the standing portions 13. For example, the heating temperature is 100 to 300 °C, more preferably 120 to 250 °C, and even more preferably, 150 to 200 °C. The structure is heated in an oven or on a hot plate.
Meanwhile, the conductive circuit layer of the substrate 11 is exposed to the bottom of the holes 141 formed by removal of the standing portions 13. In addition, if the residue of the standing portions 13 remains at the bottom of the holes 141, the residue can be removed by wet or dry cleaning after the standing portions 13 have been removed by heating. In the wet cleaning process, the residue can be removed using a solvent such as acetone, methyl ethyl ketone, γ-butyrolactone, or polyethylene glycol methyl ether acetate. In the dry cleaning process, the residue can be removed using oxide plasma, argon plasma or the like.

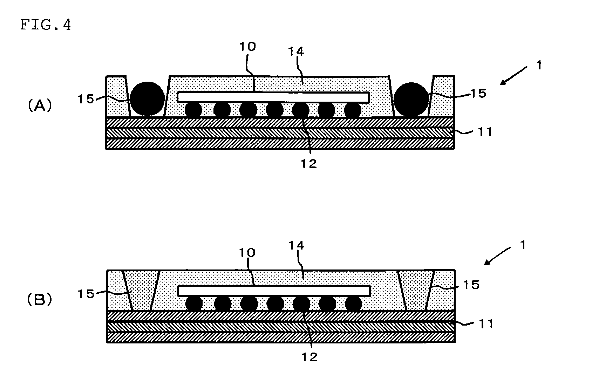

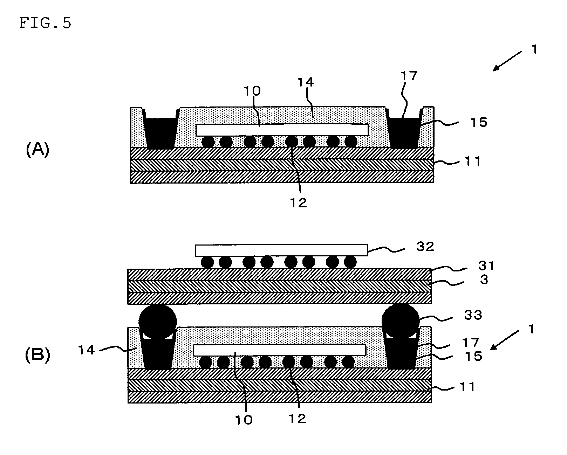

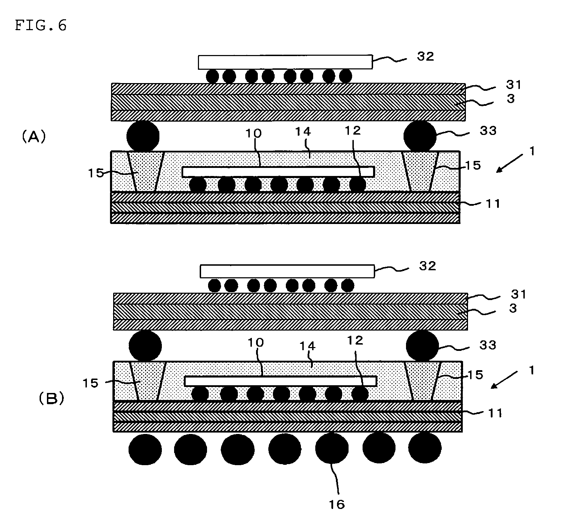

Then, as shown in Fig. 4A, a conductive material is placed in the holes 141. The conductive material 15 may be, for example, metal particles such as solder balls. Preferably, the conductive material 15 and the conductive circuit layer of the substrate 11 are heated to the melting point or higher of the conductive material 15, after which the conductive material 15 is placed in the holes 141 such that it is connected to the conductive circuit layer.
Alternatively, as shown in Fig. 4B, the conductive material 15 may be filled in the holes 141. In this case, the conductive material 15 may be, for example, a conductive paste such as a solder paste or a copper paste.
Alternatively, as shown in Fig. 5A, the film-shaped conductive material 15 may be formed on the surface of the holes 141, after which an insulating resin composition 17 may be filled in the inside of the conductive material 15. In the case in which the film-shaped conductive material 15 is placed in the holes 141, as shown in Fig. 5B, each of solder balls 33 of an upper semiconductor device 3 may be placed in each of the holes 141 such that the solder balls 33 come into contact with the conductive material 15.
Alternatively, there may also be used a method in which a film-shaped conductive material is formed on the surface of the holes 141 and the inside of the conductive material is filled with a conductive paste such as a solder paste or a copper paste.
The conductive material 15 comes into direct contact with the conductive circuit layer of the substrate 11.
In the case in which the film-shaped conductive material 15 is formed, it may have a base layer, an intermediate layer and a surface layer. In this case, for example, there may be used a method in which Ti, Cr and Cu layers are formed on the inner surface of the holes 141 by sputtering to form a base layer, after which a Cu layer is formed on the base layer by plating to form an intermediate layer, and then an Ni/Au layer is formed on the intermediate layer by plating to form a surface layer.
By the above-described processes, the semiconductor device 1 can be obtained.
Thereafter, as shown in Fig. 6A, another semiconductor device 3 is mounted on the semiconductor device 1. The other semiconductor device 3 comprises a substrate 31 and a semiconductor chip 32 mounted on the substrate 31. The backside of the semiconductor device 3 is provided with solder balls 33 serving as metal electrodes, and the other semiconductor device 3 is mounted on the semiconductor device 1 in such a manner that the solder balls 33 come into contact with the conductive material 15. Then, a stack consisting of the semiconductor device 1 and the semiconductor device 3 is heated such that the solder balls 33 are fused to the conductive material 15. As a result, a semiconductor package is obtained.
Then, as shown in Fig. 6B, solder bumps 16 are formed on the backside of the substrate 11 of the semiconductor device 1. Then, the semiconductor package is mounted on a mounting board through the solder bumps 16.

Hereinafter, the operations and effects of this embodiment will be described.
In this embodiment, the thermally decomposable standing portions 13 are formed on the substrate 11, and the encapsulating material 14 is applied such that it covers around the standing portions 13 while exposing a portion of each of the standing portions 13 from the surface of the encapsulating material 14. Then, the standing portions 13 are thermally decomposed by heating, thereby forming the holes 141 through the encapsulating material 14.
On this account, the highly reliable semiconductor device 1 can be obtained without etching the surface of the substrate 11 by a laser beam.

In addition, in this embodiment, the standing portions 13 are made of a thermally decomposable composition and have a thermal decomposition temperature (i.e., 50% weight loss temperature) of 400 °C or below, and thus they are easily thermally decomposed. This can prevent the standing portions 13 from remaining in the holes 141. Thus, the highly reliable semiconductor device can be obtained.
Particularly, polycarbonate-based resin is used as the thermally decomposable resin of the thermally decomposable resin composition constituting the standing portions 13, whereby the standing portions 13 can be thermally decomposed at relatively low temperatures.

In addition, the standing portions 13 are formed by a dispense method, whereby the height of the standing portions 13 can be ensured and the height of the standing portions 13 from the surface of the substrate 11 can be greater than the thickness of the semiconductor chip 10. This can ensure that the holes 141 are formed through the encapsulating material 14.

Furthermore, in this embodiment, the encapsulating material 14 is injected between the solder bumps 12 formed between the substrate 11 and the semiconductor chip 10. This eliminates the need to fill an underfill between the bumps 12 and can simplify the process for manufacturing the semiconductor device 1.

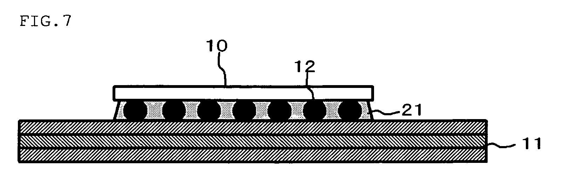

It is to be understood that the scope of the present invention is not limited to the above-described embodiment, and modifications, improvements and the like within the range in which the objects of the present invention can be achieved fall within the scope of the present invention.
For example, in the above-described embodiment, the semiconductor chip 10 is electrically connected to the substrate 11 through the solder bumps 12, but the scope of the present invention is not limited thereto and the semiconductor chip 10 may also be electrically connected to the substrate 11 through wires.
In addition, in the above-described embodiment, the encapsulating resin composition is filled into the gap between the solder bumps 12 formed between the semiconductor chip 10 and the substrate 11, but is not limited thereto. As shown in Fig. 7, an underfill 21 may also be filled into the gap between the solder bumps 12 formed between the semiconductor chip 10 and the substrate 11. Then, a semiconductor package may be manufactured in the same manner as the first embodiment.

### EXAMPLES

Hereinafter, the examples of the present invention will be described.

### Example 1

According to the same method as the above-described embodiment, standing portions were formed and holes were formed through an encapsulating material. Specifically, Example 1 was carried out in the following manner.

### <Synthesis of 1,4-polybuthylene carbonate resin>

To a three-neck flask equipped with a stirrer, a raw material inlet and a nitrogen gas inlet, 1,4-butanediol (168 g, 1.864 mol) and diethyl carbonate (264.2 g, 2.236 mol) were added and the mixture was dissolved by heating to a temperature of 90 to 100 °C in a nitrogen atmosphere. Then, a 20% sodium ethoxide ethanol solution (80 ml, 0.186 mol) was added thereto, and the mixture was stirred at 90 to 100 °C in a nitrogen atmosphere for 1 hour. Then, the internal pressure of the reactor was reduced to about 30 kPa, followed by stirring at 90 to 100 °C for 1 hour and at 120 °C for 1 hour. Then, the reaction solution was stirred under a vacuum of 0.1 kPa at 150 °C for 1 hour and at 180 °C for 2 hours.

The reaction product obtained as described above was dissolved in tetrahydrofuran (2 L) and filtered to remove the catalyst residue. Then, the filtrate was added to a solution (20 L) of distilled water/methanol = 1/9, and the precipitate was collected and sufficiently washed with a solution (10 L) of distilled water/methanol = 1/9, thereby obtaining 125 g (48% yield) of 1,4-polybuthylene carbonate. The synthesized 1,4-polybuthylene carbonate had a weight-average molecular weight of 35,000 as measured by GPC.
The 1,4-polybuthylene carbonate thus obtained had a 50% weight loss temperature of 311 °C. In addition, the difference between the 95% weight loss temperature and 5% weight loss temperature of the obtained 1,4-polybuthylene carbonate was 34 °C. Furthermore, the obtained 1,4-polybuthylene carbonate had a 5% weight loss temperature of 277 °C.
As used herein, the terms "50% weight loss temperature", "95% weight loss temperature" and "5% weight loss temperature" mean the temperatures corresponding to weight losses of 50%, 95% and 5%, respectively, as measured by thermogravimetry (Tg)/differential thermal analysis (DTA). The TG/DTA analysis can be performed by precisely weighing about 10 mg of the thermally decomposable resin component and performing TG/DTA analysis using a TG/DTA system (manufactured by Seiko Instruments Inc.) in a nitrogen atmosphere at a heating rate of 5 °C/min.

### <Preparation of thermally decomposable resin composition>

100 g of 1, 4-polybuthylene carbonate obtained as described above, 5 g of Rhodorsil Photoinitiator 2074 (FABA) (manufactured by Rhodia Japan, Ltd.) as a photoacid initiator, and 1.5 g of 1-chloro-4-propoxythioxanthone (Speedcure CPTX (product name) commercially available from Lambson, Ltd., GB) as a sensitizer were dissolved in 159.8 g of anisole (solvent), thereby preparing a thermally decomposable resin composition having a resin concentration of 40%.

### <Formation of standing portions>

The prepared thermally decomposable resin composition having a resin concentration of 40% was dispensed by a dispenser (manufactured by Asymtek; Model DV-01) on an FR-4 substrate (35 mm corner) having gold pads at the four corners of the surface. Then, the resin composition was dried at 100 °C for 30 minutes to evaporate anisole, thereby forming standing portions, each having 600 µm square and a thickness of 300 µm.

### <Application of encapsulating material>

Then, an encapsulating resin composition was compression-molded on the entire surface of the FR-4 substrate at a temperature of 125 °C and a pressure 5.9 MPa in such a manner that a portion of each of the standing portions was exposed, thereby obtaining a sample for evaluation comprising a 300 µm -thick encapsulating material covering around the standing portions.
As the encapsulating material, EME-7351 (manufactured by SUMITOMO BAKELITE CO., LTD.) was used.
Meanwhile, the upper surface of the standing portions was exposed from the encapsulating material.

### <Curing of encapsulating material and removal of standing portions (formation of holes)>

Then, the sample for evaluation was placed in an oven, and the encapsulating material was thermally cured at 175 °C for 8 hours while the thermally decomposable resin composition was thermally decomposed to leave holes.
The holes of the resulting sample were observed with a stereoscopic microscope, and as a result, the residue of the thermally decomposable resin composition was not observed on the surface of the gold pads formed on the substrate surface and the wall surface of the holes.
Then, a conductive material was placed in the holes remaining after removal of the standing portions, thereby obtaining a semiconductor device.

### Example 2

### <Preparation of thermally decomposable resin composition>

The 1,4-polybuthylene carbonate obtained in Example 1 was dissolved in 150 g of anisole (solvent) to prepare a thermally decomposable resin composition having a resin concentration of 40%.

### <Formation of standing portions, application of encapsulating material and curing of encapsulating material>

The formation of standing portions, the application of an encapsulating material and the curing of the encapsulating material were carried out in the same manner as described in Example 1.

### <Removal of standing portions (formation of holes)>

Then, a sample for evaluation was thermally treated at 320 °C for 30 minutes while the thermally decomposable resin composition constituting the standing portions were thermally decomposed to leave holes.
The resulting sample was observed with a stereoscopic microscope, and as a result, the residue of the thermally decomposable resin composition was not observed on the surface of the gold pads formed on the substrate surface and the wall surface of the holes.
Then, a conductive material was placed in the holes remaining after removal of the standing portions, thereby obtaining a semiconductor device.

In the above examples, 1,4-polybuthylene carbonate was used as the thermally decomposable resin component of the standing portions. It is to be understood that, even if polypropylene carbonate or the like is used as the thermally decomposable resin component, it can be thermally decomposable at 250 °C within 1 hour and a semiconductor device can be obtained in the same manner as described in Example 1.

This application claims priority based on Japanese patent application No. 2009-270110 filed on November 27, 2009, the disclosure of which is incorporated herein by reference in its entirety.

## Claims

1. A method for manufacturing an electronic device, comprising:
placing an electronic component on a substrate;
forming standing portions on a surface of the substrate on which the electronic component is placed, the standing portion comprising a thermally decomposable resin;
applying an encapsulating material so as to encapsulate the electronic component and cover around the standing portions while exposing a portion of each of the standing portions from the surface of the encapsulating material;
heating the standing portions to decompose and remove the standing portions, thereby forming holes through the encapsulating material; and
placing a conductive material in the holes.

2. The method according to claim 1, wherein the electronic component is a semiconductor chip and the substrate is a semiconductor chip mounting substrate.

3. The method according to claim 1 or 2, wherein a circuit is formed on the surface of the substrate on which the electronic component is placed, and the standing portions are formed on the circuit in the step of forming the standing portions on the surface of the substrate on which the electronic component is placed.

4. The method according to any one of claims 1 to 3, wherein the standing portions comprises a total of 50 wt% or more of a thermally decomposable resin selected from the group consisting of polycarbonate-based resin, polyacetal-based resin, polyester-based resin, polyamide-based resin, polyimide-based resin, polyether-based resin, polyurethane-based resin, and (meth)acrylate-based resin.

5. The method according to any one of claims 1 to 4, wherein the standing portions comprise polycarbonate-based resin as their main component.

6. The method according to any one of claims 1 to 5, wherein a resin constituting the standing portions is dispensed on the substrate by a dispenser, thereby the standing portions is formed, in the step of forming the standing portions on the surface of the substrate on which the electronic component is placed.

7. The method according to any one of claims 1 to 6, wherein the encapsulating material is applied so as to cover the entire surface of the substrate in the step of applying the encapsulating material.

8. The method according to claim 1, wherein the thermally decomposable resin has a 50% weight loss temperature of 400 °C or lower.

9. The method according to claim 1, wherein the thermally decomposable resin has a 5% weight loss temperature of 50 °C or higher.

10. The method according to claim 1, wherein the thermally decomposable resin has a difference between 95% weight loss temperature and 5% weight loss temperature of equal to or more than 1 °C and equal to or less than 300 °C.

11. An electronic device manufactured according to the method as set forth in any one in claims 1 to 10.

12. A method for manufacturing an electronic device package comprising an electronic device, manufactured according to the method as set forth in any one of claims 1 to 10, and an additional electronic device stacked with the manufactured electronic device, the method comprising:
mounting the additional electronic device on the electronic device, manufactured according to the method as set forth in any one of claims 1 to 10, in such a manner that a conductive material in the manufactured electronic device comes into contact with an electrode formed on the additional electronic device, thereby obtaining a stack composed of the manufactured electronic device and the additional electronic device; and
heating the stack to bond the conductive material to the electrode of the additional electronic device.

13. An electronic device package manufactured according to the as set forth in claim 12.
